# EUROPEAN PATENT APPLICATION

(11) **EP 4 611 515 A1**
(43) Date of publication of application: **03.09.2025**
(21) Application number: 24223113.2
(22) Date of filing: 23.12.2024
(51) Int. Cl.: H10K 59/124, H10K 59/80, H10K 59/122

(54) **DISPLAY DEVICE**

(30) Priority: 29.02.2024 KR 20240029333
(71) Applicant: LG Display Co., Ltd., Seoul, 07336 (KR)
(72) Inventor: SHIN, Nara, 10845 Paju-si (KR); KIM, Daehee, 10845 Paju-si (KR); KIM, Byungjin, 10845 Paju-si (KR); KIM, Harin, 10845 Paju-si (KR)
(74) Representative: Morrall, Jonathan Ian McLachlan

(57) **Abstract**

Provided is a display device, including: a substrate; a first electrode layer disposed on the substrate; a bank layer disposed on the first electrode layer and configured to define a plurality of subpixels; a light emitting layer disposed on the bank; and an encapsulation layer disposed on the light emitting layer, wherein the encapsulation layer includes a concave portion.

## Description

### CROSS-REFERENCE TO RELATED APPLICATION

This application claims priority from Korean Patent Application No. 10-2024-0029333, filed on February 29, 2024, which is hereby incorporated by reference for all purposes as if fully set forth herein.

### BACKGROUND

### Field

Embodiments of the disclosure relate to a display device.

### Description of Related Art

A display panel of a display device may include a display area where images are displayed and a non-display area where no image is displayed. Since various structures, various circuits and lines need to be disposed in the non-display area (also referred to as a bezel area), it is not easy to reduce the bezel of the display panel.

In particular, when a structure for preventing or at least reducing moisture penetration is formed in the bezel of the display panel, it is more difficult to reduce the bezel size.

### BRIEF SUMMARY

Embodiments of the disclosure may provide a display device capable of delaying moisture penetration in the bezel area.

Embodiments of the disclosure may provide a display device capable of delaying moisture penetration in the bezel area while implementing an extremely narrow bezel.

Embodiments of the disclosure may provide a display device comprising a substrate including a display area and a non-display area surrounding the display area, an insulation layer positioned on the substrate and including at least one concave portion in an area adjacent to a boundary between the display area and the non-display area, or the non-display area, a bank layer positioned in the display area, positioned on the insulation layer, and including an opening area, and an inorganic encapsulation layer positioned on the bank layer, covering the concave portion, and including at least one uneven portion in the concave portion.

Embodiments of the disclosure may provide a display device comprising a substrate including a display area and a non-display area surrounding the display area, an insulation layer positioned on the substrate and including at least one concave portion positioned in an area adjacent to a boundary between the display area and the non-display area or in the non-display area, a bank layer positioned in the display area, positioned on the insulation layer, and including an opening area, an inorganic encapsulation layer including at least one hole positioned on the bank layer, and a pattern layer including fluorine in the hole.

Embodiments of the disclosure may provide a display device comprising a substrate including a display area and a non-display area surrounding the display area, a bank layer positioned in the display area, positioned on the insulation layer, including an opening area, and including at least one first groove positioned between the opening area and the concave portion, a passivation layer positioned on the bank layer, covering the at least one first groove, and including at least one second groove positioned on the at least one first groove, and a dummy intermediate layer positioned on an upper surface of the passivation layer.

According to embodiments of the disclosure, there may be provided a display device capable of delaying moisture penetration in the bezel area.

According to embodiments of the disclosure, there may be provided a display device capable of process optimization by implementing an extremely narrow bezel while delaying moisture penetration in the bezel area.

### DESCRIPTION OF DRAWINGS

The above and other objects, features, and advantages of the disclosure will be more clearly understood from the following detailed description, taken in conjunction with the accompanying drawings, in which:
FIG. 1 is a view illustrating a system configuration of a display device according to embodiments of the disclosure;
FIG. 2 illustrates an equivalent circuit diagram illustrating a subpixel in a display panel according to embodiments of the disclosure;
FIG. 3 is a plan view illustrating a display panel according to embodiments of the disclosure;
FIGS. 4A, 4B, and 4C are cross-sectional views taken along I-I', II-II', and III-III', respectively, of FIG. 3 according to embodiments of the disclosure; and
FIGS. 5A, 5B, 5C, 5D, 6A, 6B, 6C, 6D, and 7 are enlarged cross-sectional views of part A of FIG. 4A according to embodiments of the disclosure.

### DETAILED DESCRIPTION

In the following description of examples or embodiments of the disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the disclosure, detailed descriptions of well-known functions and components incorporated herein will be omitted when it is determined that the description may make the subject matter in some embodiments of the disclosure rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the disclosure. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the disclosure are described in detail with reference to the accompanying drawings.

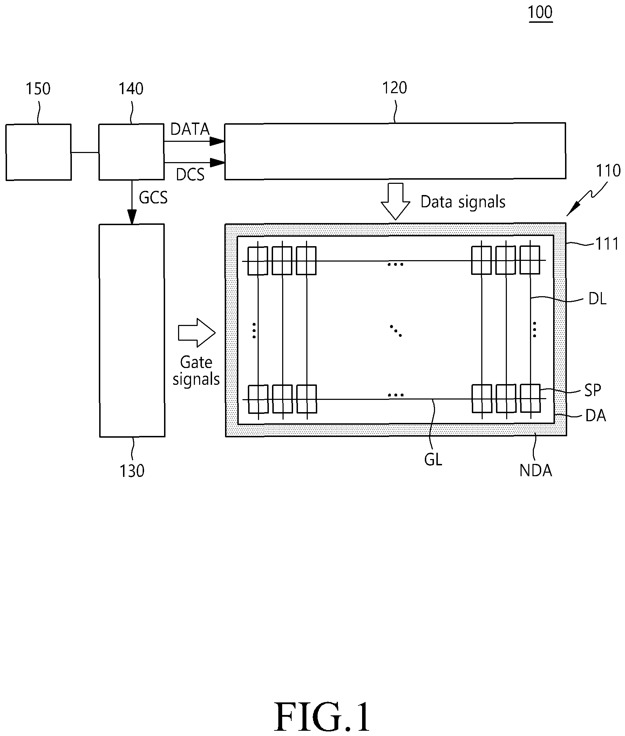

FIG. 1 is a view illustrating a system configuration of a display device 100 according to embodiments of the disclosure.

Referring to FIG. 1, a display device 100 according to embodiments of the disclosure may include a display panel 110 and display driving circuits, as components for displaying images.

The display driving circuits are circuits for driving the display panel 110 and may include a data driving circuit 120, a gate driving circuit 130, and a display controller 140.

The display panel 110 may include a substrate 111 and a plurality of subpixels SP disposed on the substrate 111.

The substrate 111 of the display panel 110 may include a display area DA capable of displaying an image and a non-display area NDA positioned outside the display area DA.

A plurality of subpixels SP for image displaying may be disposed in the display area DA, and the non-display area NDA may include a pad area PA positioned in a first direction from the display area DA.

In the display panel 110 according to embodiments of the disclosure, the non-display area NDA may be very small.

In the disclosure, the non-display area NDA may also be referred to as a "bezel."

For example, the non-display area NDA may include a first non-display area positioned outside the display area DA in a first direction, a second non-display area positioned outside the display area DA in a second direction crossing the first direction, a third non-display area positioned outside the display area DA in a direction opposite to the first direction, and a fourth non-display area positioned outside the display area DA in a direction opposite to the second direction.

At least one or two of the first to fourth non-display areas may include a pad area where the data driving circuit 120 is connected or bonded.

At least two or three of the first to fourth non-display areas where the pad area is not included may be very small.

As another example, the boundary area between the display area DA and the non-display area NDA may be bent so that the non-display area NDA may be positioned under the display area.

In this case, the non-display area NDA may be nearly invisible to the user when the user views the display area DA from the front.

Various types of signal lines for driving a plurality of subpixels SP may be disposed on the substrate 111 of the display panel 110.

The display device 100 according to embodiments of the disclosure may be a liquid crystal display device or a self-emission display device in which the display panel 110 emits light by itself.

When the display device 100 according to the embodiments of the disclosure is a self-emission display device, each of the plurality of subpixels SP may include a light emitting element.

For example, the display device 100 according to embodiments of the disclosure may be an organic light emitting diode display in which the light emitting element is implemented as an organic light emitting diode (OLED).

As another example, the display device 100 according to embodiments of the disclosure may be an inorganic light emitting display device in which the light emitting element is implemented as an inorganic material-based light emitting diode.

As another example, the display device 100 according to embodiments of the disclosure may be a quantum dot display device in which the light emitting element is implemented as a quantum dot (QD) which is self-emission semiconductor crystal.

The structure of each of the plurality of subpixels SP may vary according to the type of the display device 100.

For example, when the display device 100 is a self-emission display device in which the subpixels SP emit light by themselves, each subpixel SP may include a light emitting element that emits light by itself, one or more transistors, and one or more capacitors.

For example, various types of signal lines may include a plurality of data lines DL transferring N data signals (also referred to as data voltages or image signals) and a plurality of gate lines GL transferring gate signals (also referred to as scan signals).

The plurality of data lines DL and the plurality of gate lines GL may cross each other.

Each of the plurality of data lines DL may be disposed to extend in the first direction. Each of the plurality of gate lines GL may be disposed to extend in the second direction.

Here, the first direction may be a column direction and the second direction may be a row direction.

The first direction may be the row direction, and the second direction may be the column direction.

For convenience of description, described below is an example in which each of the plurality of data lines DL is disposed in the column direction, and each of the plurality of gate lines GL is disposed in the row direction.

The data driving circuit 120 is a circuit for driving the plurality of data lines DL, and may out data signals to the plurality of data lines DL.

The data driving circuit 120 may receive digital image data DATA from the display controller 140 and may convert the received image data DATA into analog data signals and output them to the plurality of data lines DL.

For example, the data driving circuit 120 may be connected with the display panel 110 by a tape automated bonding (TAB) method or connected to a bonding pad of the display panel 110 by a chip on glass (COG) or chip on panel (COP) method or may be implemented by a chip on film (COF) method and connected with the display panel 110.

The data driving circuit 120 may be connected to one side (e.g., an upper or lower side) of the display panel 110.

In contrast, depending on the driving scheme or the panel design scheme, data driving circuits 120 may be connected with both the sides (e.g., both the upper and lower sides) of the display panel 110, or two or more of the four sides of the display panel 110.

The data driving circuit 120 may be connected outside the display area DA of the display panel 110, but alternatively, the data driving circuit 120 may be disposed in the display area DA of the display panel 110.

The gate driving circuit 130 is a circuit for driving the plurality of gate lines GL, and may output gate signals to the plurality of gate lines GL.

The gate driving circuit 130 may receive a first gate voltage corresponding to a turn-on level voltage and a second gate voltage corresponding to a turn-off level voltage, along with various gate driving control signals GCS, generate gate signals, and supply the generated gate signals to the plurality of gate lines GL.

In the display device 100 according to embodiments of the disclosure, the gate driving circuit 130 may be embedded, in a gate in panel (GIP) type, in the display panel 110.

When the gate driving circuit 130 is of the gate in panel type, the gate driving circuit 130 may be formed on the substrate 111 of the display panel 110 during the manufacturing process of the display panel 110.

In the display device 100 according to embodiments of the disclosure, the gate driving circuit 130 may be disposed in the display area DA of the display panel 110.

For example, the gate driving circuit 130 may be disposed in a first partial area in the display area DA (e.g., a left area or a right area in the display area DA).

As another example, the gate driving circuit 130 may be disposed in a first partial area in the display area DA (e.g., a left area or right area in the display area DA) and a second partial area (e.g., a right area or left area in the display area DA) .

In the disclosure, the gate driving circuit 130 embedded in the display panel 110 in a gate-in-panel type may also be referred to as a "gate-in-panel circuit."

As described above, the gate driving circuit 130 of the gate-in-panel type is not connected to or disposed in the non-display area NDA of the display panel 110, but is disposed in the display area DA, thereby significantly reducing the bezel of the display panel 110.

The display controller 140 is a device for controlling the data driving circuit 120 and the gate driving circuit 130 and may control driving timings for the plurality of data lines DL and driving timings for the plurality of gate lines GL.

The display controller 140 may supply a data driving control signal DCS to the data driving circuit 120 to control the data driving circuit 120 and may supply a gate driving control signal GCS to the gate driving circuit 130 to control the gate driving circuit 130.

The display controller 140 may be implemented as a separate component from the data driving circuit 120, or the display controller 140 and the data driving circuit 120 may be integrated into an integrated circuit (IC).

The display controller 140 may be a timing controller used in typical display technology, a control device that may perform other control functions as well as the functions of the timing controller, or a control device other than the timing controller, or may be a circuit in the control device.

The display controller 140 may be implemented as various circuits or electronic components, such as an integrated circuit (IC), a field programmable gate array (FPGA), an application specific integrated circuit (ASIC), or a processor.

The display controller 140 may be mounted on a printed circuit board or a flexible printed circuit and may be electrically connected with the data driving circuit 120 and the gate driving circuit 130 through the printed circuit board or the flexible printed circuit.

The display controller 140 may transmit/receive signals to/from the data driving circuit 120 according to one or more predetermined interfaces.

The interface may include, e.g., a low voltage differential signaling (LVDS) interface, an embedded clock point-point interface (EPI), and a serial peripheral interface (SPI).

To provide a touch sensing function as well as an image display function, the display device 100 according to embodiments of the disclosure may include a touch sensor and a touch sensing circuit that senses the touch sensor to detect whether a touch occurs by a touch object, such as a finger or pen, or the position of the touch.

The touch sensing circuit may include a touch driving circuit that drives and senses the touch sensor and generates and outputs touch sensing data and a touch controller that may detect an occurrence of a touch or the position of the touch using touch sensing data.

The touch sensor may include a plurality of touch electrodes.

The touch sensor may further include a plurality of touch lines for electrically connecting the plurality of touch electrodes and the touch driving circuit.

The touch sensor may be present in a touch panel form outside the display panel 110 or may be present inside the display panel 110.

When the touch panel, in the form of a touch panel, exists outside the display panel 110, the touch panel is of an external type.

When the touch sensor is of the external type, the touch panel and the display panel 110 may be separately manufactured or may be combined during an assembly process.

The external-type touch panel may include a touch panel substrate and a plurality of touch electrodes on the touch panel substrate.

When the touch sensor is present inside the display panel 110, the touch sensor may be formed on the substrate, together with signal lines and electrodes related to display driving, during the manufacturing process of the display panel 110.

The touch driving circuit may supply a touch driving signal to at least one of the plurality of touch electrodes and may sense at least one of the plurality of touch electrodes to generate touch sensing data.

The touch sensing circuit may perform touch sensing in a self-capacitance sensing scheme or a mutual-capacitance sensing scheme.

When the touch sensing circuit performs touch sensing in the self-capacitance sensing scheme, the touch sensing circuit may perform touch sensing based on capacitance between each touch electrode and the touch object (e.g., finger or pen).

According to the self-capacitance sensing scheme, each of the plurality of touch electrodes may serve both as a driving touch electrode and as a sensing touch electrode.

The touch driving circuit may drive all or some of the plurality of touch electrodes and sense all or some of the plurality of touch electrodes.

When the touch sensing circuit performs touch sensing in the mutual-capacitance sensing scheme, the touch sensing circuit may perform touch sensing based on capacitance between the touch electrodes.

According to the mutual-capacitance sensing scheme, the plurality of touch electrodes may be divided into driving touch electrodes and sensing touch electrodes.

The touch driving circuit may drive the driving touch electrodes and sense the sensing touch electrodes.

The touch driving circuit and the touch controller included in the touch sensing circuit may be implemented as separate devices or as a single device.

The touch driving circuit and the data driving circuit may be implemented as separate devices or as a single device.

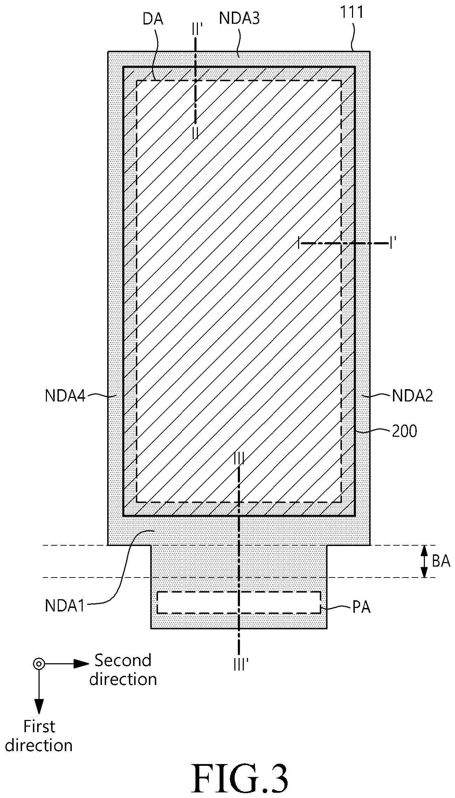

Meanwhile, a plurality of touch lines (a plurality of touch routing lines) for electrically connecting the plurality of touch electrodes constituting the touch sensors and the touch driving circuit may be disposed across the display area DA without bypassing the non-display area (the second to fourth non-display areas NDA2, NDA3, and NDA4 of FIG. 3) in which the pad area (the pad area PA of FIG. 3) is not present in the non-display area NDA, and may extend to the pad area PA of FIG. 3.

Accordingly, the size of the non-display area (the second to fourth non-display areas NDA2, NDA3, and NDA4 of FIG. 3) in which the pad area (the pad area PA of FIG. 3) is not indluded may be significantly reduced, and thus the bezel size may be substantially reduced.

The display device 100 may further include a power supply circuit for supplying various types of power to the display driver integrated circuit or the touch sensing circuit.

The display device 100 according to embodiments of the disclosure may be a mobile terminal, such as a smart phone or a tablet, or a monitor or television (TV) in various sizes but, without limited thereto, may be a display in various types and various sizes capable of displaying information or images.

The display device 100 according to embodiments of the disclosure may further include an electronic device such as a camera (image sensor), a detection sensor, or the like.

For example, the detection sensor may be a sensor that detects an object or a human body by receiving light such as infrared rays, ultrasonic waves, or ultraviolet rays.

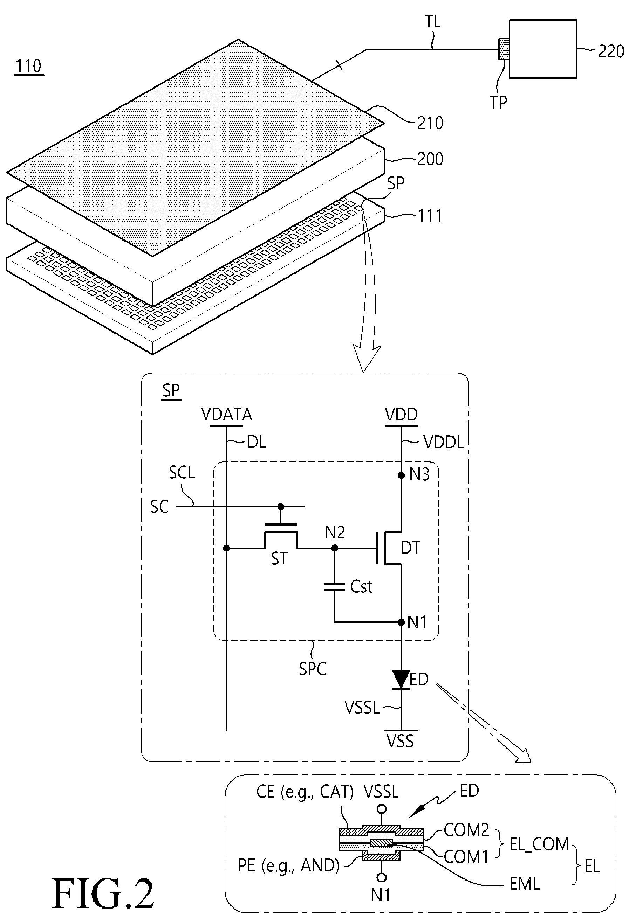

FIG. 2 is an equivalent circuit of a subpixel in a display panel 110 according to embodiments of the disclosure.

Referring to FIG. 2, the display panel 110 may include a substrate 111 disposed in a plurality of subpixels SP and an encapsulation layer 200 on the substrate 111.

Here, the encapsulation layer 200 may also be referred to as an encapsulation substrate or an encapsulation portion.

Referring to FIG. 2, when the display device 100 according to embodiments of the disclosure is a self-luminous display device, each of the plurality of subpixels SP disposed on the substrate 111 may include a light emitting element ED and a subpixel circuit SPC for driving the light emitting element ED.

Referring to FIG. 2, the subpixel circuit SPC may include a plurality of pixel driving transistors and at least one capacitor for driving the light emitting element ED.

In the disclosure, the subpixel circuit SPC may drive the light emitting element ED by supplying a driving current to the light emitting element ED at a predetermined timing.

The light emitting element ED may be driven by a driving current to emit light.

The plurality of pixel driving transistors may include a driving transistor DT for driving the light emitting element ED and a scan transistor ST that is turned on or off according to the scan signal SC.

The driving transistor DT may supply a driving current to the light emitting element ED.

The scan transistor ST may control the electrical state of a corresponding node in the subpixel circuit SPC or to control the state or operation of the driving transistor DT.

The at least one capacitor may include a storage capacitor Cst for maintaining a constant voltage during a frame.

To drive the subpixel SP, a data signal VDATA as an image signal and a scan signal SC as a gate signal may be applied to the subpixel SP.

Further, for driving the subpixel SP, a common pixel driving voltage including the first common driving voltage VDD and the second common driving voltage VSS may be applied to the subpixel SP.

The light emitting element ED may include a pixel electrode PE, an intermediate layer EL, and a common electrode CE. However, the present disclosure is not limited to it. In an embodiment, the light emitting element ED may include a first electrode layer, a light emitting layer, and a second electrode layer.

The intermediate layer EL may be positioned between the pixel electrode PE and the common electrode CE.

For example, the pixel electrode PE may be an anode electrode AND, and the common electrode CE may be a cathode electrode CAT.

Conversely, the pixel electrode PE may be a cathode electrode CAT, and the common electrode CE may be an anode electrode AND.

Hereinafter, for convenience of description, an example where the pixel electrode PE is the anode electrode AND and the common electrode CE is the cathode electrode CAT is described.

When the light emitting element ED is an organic light emitting element, the intermediate layer EL may include a light emitting layer EML, a first common intermediate layer COM1 between the anode electrode AND and the light emitting layer EML, and a second common intermediate layer COM2 between the light emitting layer EML and the cathode electrode CAT.

The light emitting layer EML may be disposed for each subpixel SP.

In contrast, the first common intermediate layer COM1 and the second common intermediate layer COM2 may be commonly disposed over a plurality of subpixels SP.

The light emitting layer EML may be disposed for each light emitting area, and the first common intermediate layer COM1 and the second common intermediate layer COM2 may be commonly disposed over the plurality of light emitting areas and the non-light emitting area.

The first common intermediate layer COM1 and the second common intermediate layer COM2 may be collectively referred to as a common intermediate layer EL_COM.

For example, the first common intermediate layer COM1 may include a hole injection layer HIL and a hole transfer layer HTL.

The second common intermediate layer COM2 may include an electron transfer layer ETL and an electron injection layer EIL.

The hole injection layer may inject holes from the anode electrode AND to the hole transfer layer, the hole transfer layer may transport the holes to the light emitting layer EML, the electron injection layer may inject electrons from the cathode electrode CAT to the electron transfer layer, and the electron transfer layer may transport electrons to the light emitting layer EML.

For example, the cathode electrode CAT may be electrically connected to the second common driving voltage line VSSL.

The second common driving voltage VSS, which is one type of common pixel driving voltage, may be applied to the cathode electrode CAT through the second common driving voltage line VSSL.

The anode electrode AND may be electrically connected to the first node N1 of the driving transistor DT of each subpixel SP.

In the disclosure, "the second common driving voltage VSS" may also be referred to as a "base voltage VSS", and "the second common driving voltage line VSSL" may also be referred to as a "base voltage line VSSL".

For example, the pixel electrode PE may be an electrode disposed in each subpixel SP, and the common electrode CE may be an electrode commonly disposed in all the subpixels SP.

Each light emitting element ED may include portions where the pixel electrode PE, the intermediate layer EL, and the common electrode CE overlap.

A predetermined light emitting area may be formed by each light emitting element ED.

For example, the light emitting area of each light emitting element ED may include an area in which the pixel electrode PE, the intermediate layer EL, and the common electrode CE overlap.

For example, the light emitting element ED may be an organic light emitting diode (OLED), an inorganic light emitting diode (LED), or a quantum dot (QD) light emitting element.

For example, when the light emitting element ED is an organic light emitting diode (OLED), the intermediate layer EL of the light emitting element ED may include an intermediate layer EL including an organic material.

The driving transistor DT may be a driving transistor for supplying a driving current to the light emitting element ED.

The driving transistor DT may be connected between the first common driving voltage line VDDL and the light emitting element ED.

The driving transistor DT may include a first node N1 electrically connected to the light emitting element ED, a second node N2 to which the data signal VDATA may be applied, and a third node N3 to which the driving voltage VDD is applied from the driving voltage line DVL.

In the driving transistor DT, the second node N2 may be a gate node, the first node N1 may be a source node or a drain node, and the third node N3 may be a drain node or a source node.

Hereinafter, for convenience of description, an example is described in which in the driving transistor DT, the second node N2 may be a gate node, the first node N1 may be a source node, and the third node N3 may be a drain node.

Referring to FIG. 2, the scan transistor ST included in the subpixel circuit SPC may be a switching transistor for transferring the data signal VDATA, which is an image signal, to the second node N2, which is the gate node of the driving transistor DT.

The scan transistor ST may be controlled to be turned on and off by the scan signal SC, which is a gate signal applied through the scan line SCL, which is a type of the gate line GL, to control electrical connection between the second node N2 of the driving transistor DT and the data line DL.

The drain electrode or the source electrode of the scan transistor ST may be electrically connected to the data line DL, the source electrode or the drain electrode of the scan transistor ST may be electrically connected to the second node N2 of the driving transistor DT, and the gate electrode of the scan transistor ST may be electrically connected to the scan line SCL.

The storage capacitor Cst may be electrically connected between the first node N1 and second node N2 of the driving transistor DT.

The storage capacitor Cst may include a first capacitor electrode electrically connected to the first node N1 of the driving transistor DT or corresponding to the first node N1 of the driving transistor DT, and a second capacitor electrode electrically connected to the second node N2 of the driving transistor DT or corresponding to the second node N2 of the driving transistor DT.

The capacitor Cst may be an external capacitor intentionally designed to be outside the driving transistor DT, but not a parasitic capacitor (e.g., Cgs or Cgd) which is an internal capacitor that may be present between the first node N1 and the second node N2 of the driving transistor DT.

Each of the driving transistor DT and the scan transistor ST may be an n-type transistor or a p-type transistor.

The display panel 110 may have a top emission structure or a bottom emission structure.

When the display panel 110 has a top emission structure, at least a portion of the subpixel circuit SPC may overlap at least a portion of the light emitting element ED in a vertical direction.

In contrast, when the display panel 110 has a bottom emission structure, the subpixel circuit SPC may not overlap the light emitting element ED in the vertical direction.

As illustrated in FIG. 2, the subpixel circuit SPC may have a 2T (Transistor)1C (Capacitor) structure including two transistors DT and ST and one capacitor Cst. In some cases, the subpixel circuit SPC may further include one or more transistors or may further include one or more capacitors.

For example, the subpixel circuit SPC may have an 8T1C structure including 8 transistors and 1 capacitor.

As another example, the subpixel circuit SPC may have a 6T2C structure including 6 transistors and 2 capacitors.

As another example, the subpixel circuit SPC may have a 7T1C structure including 7 transistors and 1 capacitor.

Depending on the structure of the subpixel circuit SPC, the type and number of gate lines or the gate signals supplied to the subpixel SP may vary.

Further, the type and the number of common pixel driving voltages supplied to the subpixel SP may vary according to the structure of the subpixel circuit SPC.

Since the circuit elements (especially the light emitting element implemented as an organic light emitting diode including an organic material) in each subpixel SP are vulnerable to external moisture or oxygen, the encapsulation layer 200 for preventing external moisture or oxygen from penetrating into the circuit elements (especially the light emitting element) may be disposed on the display panel 110.

The encapsulation layer 200 may be configured in various forms so that the light emitting elements ED do not contact moisture or oxygen.

Referring to FIG. 2, the display device 100 according to embodiments of the disclosure may further include a touch sensor layer 210 including a plurality of sensor electrodes and a touch sensing circuit 220 configured to sense the plurality of sensor electrodes to determine the presence or absence of a touch or the coordinates of a touch.

The touch sensor layer 210 may be embedded in the display panel 110.

For example, the touch sensor layer 210 may be disposed on the encapsulation layer 200 in the display panel 110.

The display panel 110 may include not only the touch sensor layer 210, but also a plurality of touch pads where the touch sensing circuit 220 is electrically connected, and a plurality of touch routing wires TL for electrically connecting the plurality of sensor electrodes included in the touch sensor layer 210 to the plurality of touch pads where the touch sensing circuit 220 is connected.

The display device 100 according to an embodiment of the disclosure may have an extremely narrow bezel structure in which the non-display area NDA of the display panel 110 is very small or almost absent.

Hereinafter, an extremely narrow bezel structure of the display panel 110 of the display device 100 according to an embodiment of the disclosure is described.

FIG. 3 is a plan view of a display panel 110 according to embodiments of the disclosure.

Referring to FIG. 3, the substrate 111 of the display panel 110 according to embodiments of the disclosure may include a display area DA in which an image may be displayed and a non-display area NDA in which an image is not displayed.

Referring to FIG. 3, the non-display area NDA may include a first non-display area NDA1 positioned in the first direction from the display area DA, a second non-display area NDA2 positioned in the second direction from the display area DA, a third non-display area NDA3 positioned in a direction opposite to the first direction from the display area DA, and a fourth non-display area NDA4 positioned in a direction opposite to the second direction from the display area DA.

For example, the first direction may be a column direction (Y-axis direction), and the second direction crossing the first direction may be a row direction (X-axis direction).

The first non-display area NDA1 may include a pad area PA in which a plurality of pads are disposed.

In the pad area PA, a plurality of pads where the driving circuit is electrically connected may be disposed.

A plurality of driving circuits or printed circuit boards may be electrically connected.

For example, the plurality of pads may include a plurality of display pads and a plurality of touch pads.

A plurality of data lines, a first common driving voltage line VDDL, a second common driving voltage line VSSL, and the like may be electrically connected to the plurality of display pads.

A plurality of touch routing lines TL may be electrically connected to the plurality of touch pads.

The first non-display area NDA1 may further include a bending area BA.

In this case, the substrate 111 may be a flexible substrate.

In some cases, the first non-display area NDA1 may not include the bending area BA.

The display panel 110 may further include a ground line disposed in the non-display area NDA of the substrate 111.

The ground line may be disposed from one point of the pad area PA to another point of the pad area PA via the second non-display area NDA2, the third non-display area NDA3, and the fourth non-display area NDA4.

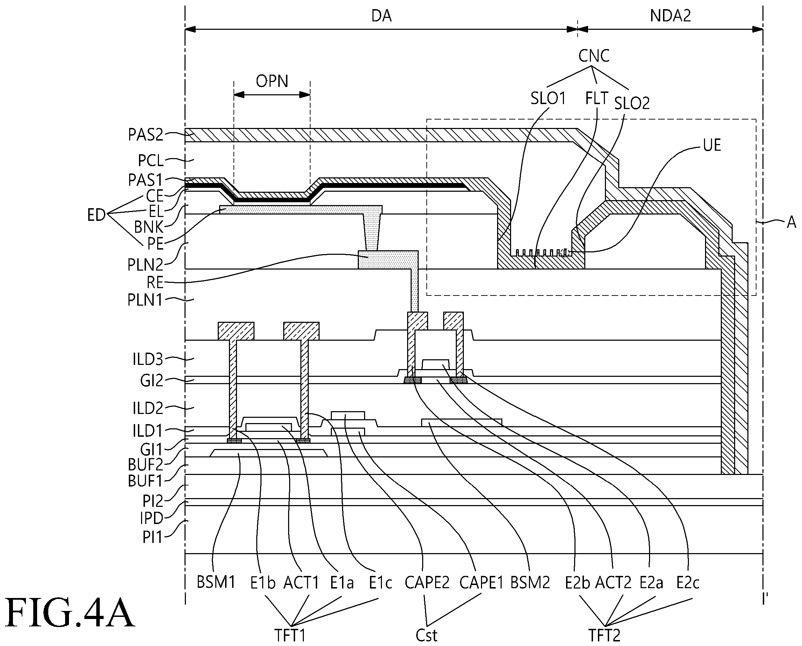

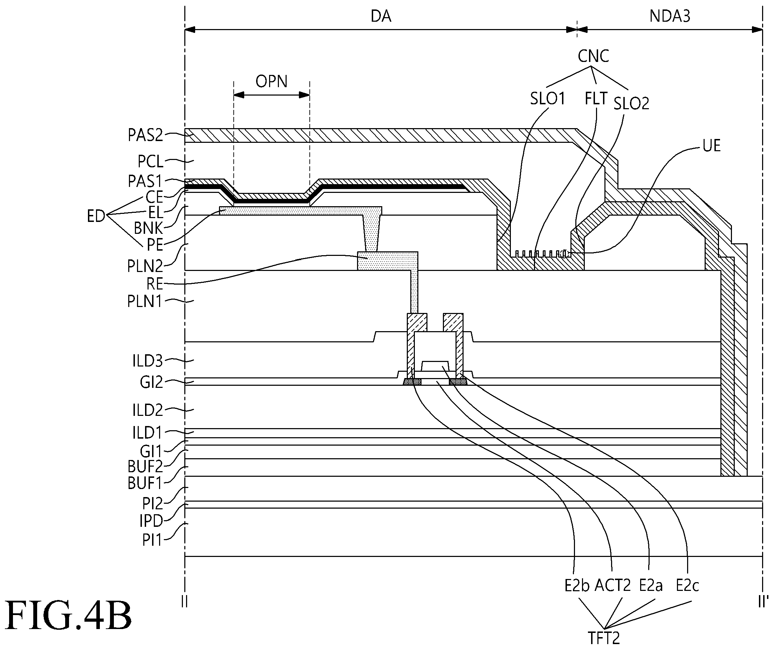

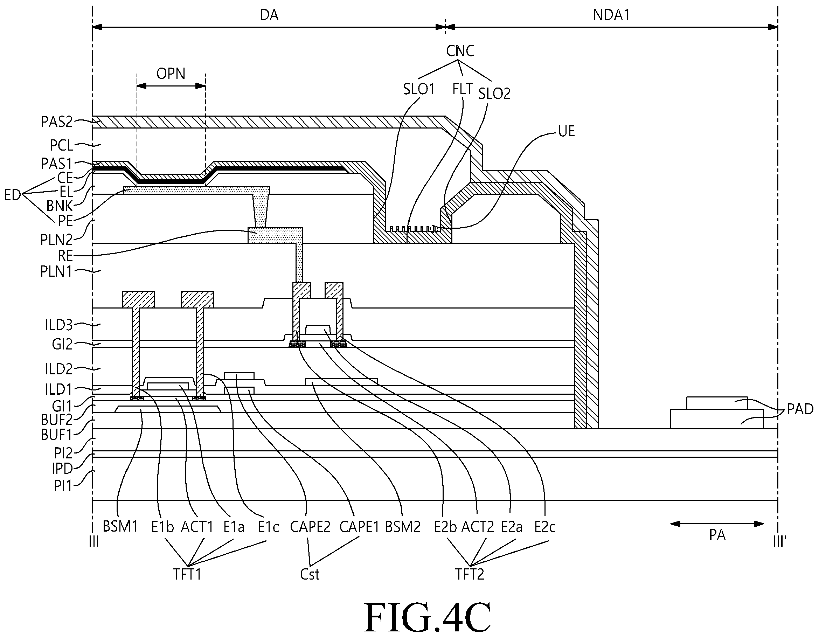

FIGS. 4A, 4B, and 4C are cross-sectional views taken along I-I', II-II', and III-III', respectively, of FIG. 3 according to embodiments of the disclosure.

FIG. 4A is a cross-sectional view taken along line I-I' of FIG. 3, FIG. 4B is a cross-sectional view taken along line II-II' of FIG. 3, and FIG. 4C is a cross-sectional view taken along line III-III' of FIG. 3.

Referring to FIG. 4A, a display panel 110 according to embodiments of the disclosure may include transistors TFT1 and TFT2, a light emitting element ED, and encapsulation layers PAS1, PCL, and PAS2 from a vertical structure perspective.

The substrate may be a single layer or multiple layers.

When the substrate includes multiple layers, the substrate may include a first substrate PI1, a substrate intermediate layer IPD, and a second substrate PI2.

The substrate intermediate layer IPD may be positioned between the first substrate PI1 and the second substrate PI2.

For example, each of the first substrate PI1 and the second substrate PI2 may be a polyimide layer.

The substrate intermediate layer IPD may be an inorganic insulation layer.

When an electric charge is charged to the first substrate PI1 which is a polyimide layer, the substrate intermediate layer IPD may prevent or at least reduce the electric charge from affecting transistors disposed on the second substrate PI2 through the second substrate PI2 which is a polyimide layer.

Further, the substrate intermediate layer IPD may prevent moisture or the like from penetrating upward through the first substrate PI1.

For example, the substrate intermediate layer IPD may be formed of a single layer of silicon nitride (SiNx) or silicon oxide (SiOx) or multiple layers thereof, or may be formed of a double layer of silicon dioxide (SiO2) and silicon nitride (SiNx), but is not limited thereto.

The transistors may include a first transistor TFT1 and a second transistor TFT2.

The first transistor TFT1 may include a first active layer ACT1, a first electrode E1a, a second electrode E1b, and a third electrode E1c.

The first active layer ACT1 may be a first semiconductor layer, but embodiments of the disclosure are not limited thereto.

For example, the first active layer ACT1 may be formed of an oxide semiconductor, amorphous silicon, polysilicon, or low temperature polysilicon (LTPS), but is not limited thereto.

The first transistor TFT1 may be implemented as a p-channel transistor or an n-channel transistor, but is not limited thereto.

The first electrode E1a may be a gate electrode, the second electrode E1b may be a source electrode or a drain electrode, and the third electrode E1c may be a drain electrode or a source electrode.

Hereinafter, for convenience of description, an example where the first electrode E1a is the first gate electrode E1a, the second electrode E1b is the first source electrode E1b, and the third electrode E1c is the first drain electrode E1c is described, but the disclosure is not limited thereto.

The second transistor TFT2 may include a second active layer ACT2, a fourth electrode E2a, a fifth electrode E2b, and a sixth electrode E2c.

The second active layer ACT2 may be a second semiconductor layer, but embodiments of the disclosure are not limited thereto.

For example, the second active layer ACT2 may be formed of an oxide semiconductor, amorphous silicon, polysilicon, or low temperature polysilicon (LTPS), but is not limited thereto.

The second transistor TFT2 may be implemented as a p-channel transistor or an n-channel transistor, but is not limited thereto.

For example, one of the first transistor TFT1 and the second transistor TFT2 may use an oxide semiconductor as an active layer.

As another example, one of the first transistor TFT1 and the second transistor TFT2 may use low-temperature polysilicon as an active layer.

As another example, the first transistor TFT1 and the second transistor TFT2 may use an oxide semiconductor as an active layer.

As another example, the first transistor TFT1 and the second transistor TFT2 may use low-temperature polysilicon as an active layer.

As another example, of the first transistor TFT1 and the second transistor TFT2, the driving transistor DT may use an oxide semiconductor as an active layer, and the scan transistor ST may use low-temperature polysilicon as an active layer.

As another example, of the first transistor TFT1 and the second transistor TFT2, the driving transistor DT may use low-temperature polysilicon as an active layer, and the scan transistor ST may use an oxide semiconductor as an active layer.

As another example, a transistor included in a gate driving circuit of a gate in panel (GIP) type may include an oxide semiconductor or low-temperature polysilicon as an active layer.

As another example, all the transistors configured on the substrate and transistors included in a gate driving circuit of a gate in panel (GIP) type may use an oxide semiconductor as an active layer.

The fourth electrode E2a may be a gate electrode, the fifth electrode E2b may be a source electrode or a drain electrode, and the sixth electrode E2c may be a drain electrode or a source electrode.

Hereinafter, for convenience of description, an example where the fourth electrode E2a is the second gate electrode E2a, the fifth electrode E2b is the second source electrode E2b, and the sixth electrode E2c is the second drain electrode E2c is described, but the disclosure is not limited thereto.

The second active layer ACT2 of the second transistor TFT2 may be positioned higher from the substrate than the first active layer ACT1 of the first transistor TFT1.

The second buffer layer BUF2 may be disposed under the first active layer ACT1 of the first transistor TFT1, and the second insulation layer ILD2 may be disposed under the second active layer ACT2 of the second transistor TFT2.

For example, the first active layer ACT1 of the first transistor TFT1 may be positioned on the second buffer layer BUF2, and the second active layer ACT2 of the second transistor TFT2 may be positioned on the second insulation layer ILD2.

The second insulation layer ILD2 may be positioned higher than the second buffer layer BUF2.

The storage capacitor Cst may include a first capacitor electrode CAPE1 and a second capacitor electrode CAPE2.

At least one planarization layer PLN1 and PLN2 may be disposed on the transistors TFT1 and TFT2.

The light emitting element ED may be disposed on at least one planarization layer PLN1 and PLN2.

The light emitting element ED may be a plurality of light emitting element diodes.

Each of the plurality of light emitting diodes ED may include a pixel electrode PE, an intermediate layer EL, and a common electrode CE.

Encapsulation layers PAS1, PCL, and PAS2 may be positioned on the light emitting element ED.

The encapsulation layer may be a single layer or multiple layers.

Referring to FIG. 4A, buffer layers BUF1 and BUF2 may be disposed on the substrate.

The buffer layer may be a single layer or multiple layers.

When the buffer layer includes multiple layers, the buffer layer may include a first buffer layer BUF1 and a second buffer layer BUF2.

The first active layer ACT1 of the first transistor TFT1 may be disposed on the second buffer layer BUF2.

The first active layer ACT1 may include a channel area where a channel is formed, a source connection area on one side of the channel area, and a drain connection area on the other side of the channel area.

The first gate insulation layer GI1 may be disposed on the first active layer ACT1 of the first transistor TFT1.

The first gate electrode E1a of the first transistor TFT1 may be disposed on the first gate insulation layer GI1.

The first insulation layer ILD1 may be disposed on the first gate electrode E1a of the first transistor TFT1.

The second insulation layer ILD2 may be disposed on the first insulation layer ILD1.

The second active layer ACT2 of the second transistor TFT2 may be disposed on the second insulation layer ILD2.

The second active layer ACT2 may include a channel area where a channel is formed, a source connection area on one side of the channel area, and a drain connection area on the other side of the channel area.

The third insulation layer ILD3 may be disposed on the second active layer ACT2 of the second transistor TFT2.

The third insulation layer ILD3 may be disposed on the second gate electrode E2a of the second transistor TFT2.

The first source electrode E1b and the first drain electrode E1c of the first transistor TFT1, and the second source electrode E2b and the second drain electrode E2c of the second transistor TFT2 may be disposed on the third insulation layer ILD3.

The first source electrode E1b and the first drain electrode E1c of the first transistor TFT1 may be connected to the source connection area and the drain connection area, respectively, of the first active layer ACT1 through holes of the third insulation layer ILD3, the second gate insulation layer GI2, the second insulation layer ILD2, the first insulation layer ILD1, and the first gate insulation layer GI1.

The second source electrode E2b and the second drain electrode E2c of the second transistor TFT2 may be connected to the source connection area and the drain connection area, respectively, of the second active layer ACT2 through holes of the third insulation layer ILD3 and the second gate insulation layer GI2.

The first source electrode E1b and the first drain electrode E1c of the first transistor TFT1, and the second source electrode E2b and the second drain electrode E2c of the second transistor TFT2 may include a first metal and may be disposed in the first metal layer.

Here, the first metal and the first metal layer may also be referred to as a first source-drain metal and a first source-drain metal layer.

Referring to FIG. 4A, e.g., the storage capacitor Cst may be formed by a first capacitor electrode CAPE1 and a second capacitor electrode CAPE2.

In some cases, the storage capacitor Cst may be formed by three or more capacitor electrodes, or may have a form in which two or more capacitors are connected in parallel.

Each of the first capacitor electrode CAPE1 and the second capacitor electrode CAPE2 may be disposed on various metal layers disposed in the display panel.

For example, the first capacitor electrode CAPE1 may include the same first gate metal as the first gate electrode E1a of the first transistor TFT1 on the first gate insulation layer GI1, and may be disposed in the first gate metal layer.

For example, the second capacitor electrode CAPE2 may be disposed on the first insulation layer ILD1.

For example, the first transistor TFT1 may be the scan transistor ST of FIG. 2, and the second transistor TFT2 may be the driving transistor DT of FIG. 2.

Referring to FIG. 4A, a first light blocking layer BSM1 may overlap the first active layer ACT1 of the first transistor TFT1 and may be disposed under the first active layer ACT1 of the first transistor TFT1.

For example, the first light blocking layer may be disposed between the first buffer layer BUF1 and the second buffer layer BUF2 .

Referring to FIG. 4A, a second light blocking layer BSM2 may overlap the second active layer ACT2 of the second transistor TFT2 and may be disposed under the second active layer ACT2 of the second transistor TFT2.

For example, the second light blocking layer BSM2 may be disposed between the first insulation layer ILD1 and the second insulation layer ILD2.

For example, the second light blocking layer BSM2 may be disposed in the same metal layer as the second capacitor electrode CAPE2.

Meanwhile, at least one planarization layer PLN1 and PLN2 may be disposed on the first transistor TFT1 and the second transistor TFT2.

In FIG. 4A, an example where two planarization layers PLN1 and PLN2 are disposed on the first transistor TFT1 and the second transistor TFT2 is described, but the disclosure is not limited thereto, and three planarization layers may be disposed.

Referring to FIG. 4A, the first planarization layer PLN1 may be disposed on the first transistor TFT1 and the second transistor TFT2.

For example, the first planarization layer PLN1 may be disposed while covering both the first transistor TFT1 and the second transistor TFT2.

Referring to FIG. 4A, a relay electrode RE may be disposed on the first planarization layer PLN1.

The relay electrode RE may be electrically connected to the second source electrode E2b of the second transistor TFT2 through the hole of the first planarization layer PLN1.

Here, the second source electrode E2b of the second transistor TFT2 may be electrically connected to the second capacitor electrode CAPE2 of the storage capacitor Cst.

The relay electrode RE may be disposed in the second metal layer on the first planarization layer PLN1 and may include a second metal.

The second metal and the second metal layer may also be referred to as a second source-drain metal and a second source-drain metal layer.

The second planarization layer PLN2 may be disposed on the relay electrode RE.

Referring to FIG. 4A, the light emitting element ED may be disposed on the second planarization layer PLN2.

The light emitting element ED may include a pixel electrode PE, an intermediate layer EL, and a common electrode CE.

The light emitting area of the light emitting element ED may be formed in an area where the pixel electrode PE, the intermediate layer EL, and the common electrode CE overlap and contact each other.

The pixel electrode PE may be disposed on the second planarization layer PLN2, and the bank layer BNK may be disposed on the pixel electrode PE.

The opening area of the bank layer BNK may be substantially the same as the light emitting area.

The intermediate layer EL of the light emitting element ED may be disposed on a portion of the pixel electrode PE and the bank layer BNK.

The common electrode CE may be disposed on the intermediate layer EL.

Referring to FIG. 4A, the encapsulation layers PAS1, PCL, and PAS2 may be disposed on the common electrode CE.

The encapsulation layer may prevent or at least reduce moisture or oxygen from penetrating into the light emitting element ED.

For example, the encapsulation layer may prevent or at least reduce moisture or oxygen from penetrating into the organic material included in the intermediate layer EL of the light emitting element ED.

Here, the encapsulation layer may be composed of a single layer or multiple layers, but is not limited thereto.

Referring to FIG. 4A, e.g., the encapsulation layer may include a first inorganic encapsulation layer PAS1, an organic encapsulation layer PCL, and a second inorganic encapsulation layer PAS2.

Referring to FIG. 4A, the at least one planarization layer PLN1 or PLN2 may include at least one concave portion CNC in an area adjacent to a boundary between the display area DA and the second non-display area NDA2 or in the second non-display area NDA2. As it is shown in FIG. 4A, the concave portion CNC is located in the display area DA close to the boundary between the display area DA and the second non-display area NDA2.

In FIG. 4A, an example where the concave portion CNC includes a flat portion FLT and a first side portion SLO1 and a second side portion SL02 surrounding the flat portion FLT is described.

In FIG. 4A, an example where the first side portion SLO1 and the second side portion SLO2 are partial areas of the side surface of the second planarization layer PLN2 and the flat portion FLT is a partial area of the upper surface of the first planarization layer PLN1 is described.

Referring to FIG. 4A, the first inorganic encapsulation layer PAS1 of the encapsulation layer may include at least one uneven portion UE. When the first inorganic encapsulation layer PAS1 covers the concave portion CNC, the at least one uneven portion UE is located in the concave portion CNC. The at least one uneven portion UE may also be referred to as uneven pattern UE. As show in FIG. 4A, in an embodiment, the uneven pattern UE may be formed between an interface between the first inorganic encapsulation layer PAS1 and the organic encapsulation layer PCL.

The uneven portion UE may be positioned lower than the bank layer BNK, but is not limited thereto. That is, concave portion CNC is formed in the second planarization layer PLN2 which is a lower layer of the bank layer BNK, and the concave portion CNC may be located at a position lower than the bank layer BNK.

When the uneven portion UE is disposed in the concave portion CNC, the movement path of moisture penetrating into the surfaces of the first inorganic encapsulation layer PAS1 and the organic encapsulation layer PCL may be increased to delay moisture penetration and enhance the reliability of the display panel 110.

Referring to FIG. 4B, the first transistor TFT1 and the storage capacitor Cst may not be positioned among the components described with reference to FIG. 4A.

The components of FIG. 4B may be substantially the same except for the matters regarding the first transistor TFT1 and the storage capacitor Cst among the components described with reference to FIG. 4A.

Referring to FIG. 4C, the components of FIG. 4C may be substantially the same as those described with reference to FIG. 4A except for the pad PAD positioned in the pad area PA.

Referring to FIG. 4C, a plurality of pads PAD where a driving circuit is electrically connected may be disposed in the pad area PA.

The plurality of pads PAD of the pad area PA may be positioned in the first non-display area NDA1.

The plurality of pads PAD of the pad area PA may be positioned on the substrates PI1, IPD, and PI2.

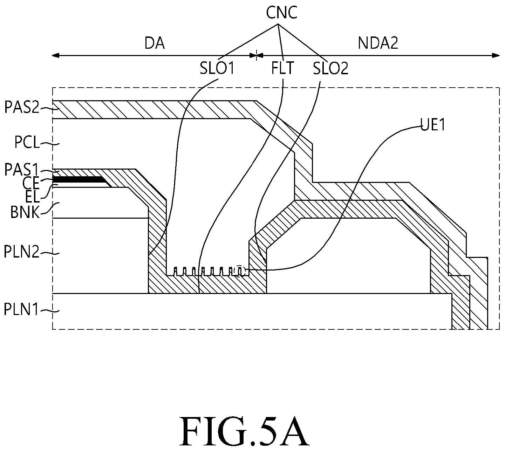

FIGS. 5A, 5B, 5C, 5D, 6A, 6B, 6C, 6D, and 7 are enlarged cross-sectional views of part A of FIG. 4A according to embodiments of the disclosure.

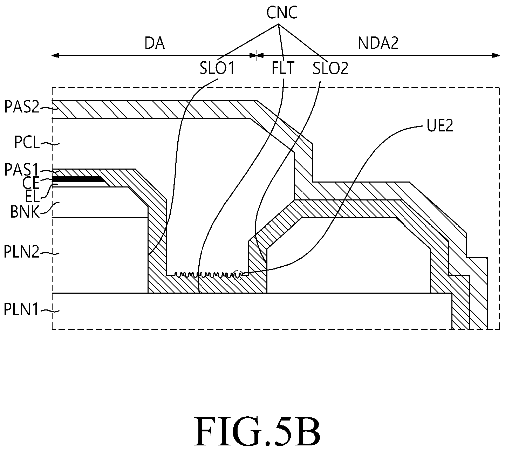

FIGS. 5A and 5B illustrate a first inorganic encapsulation layer PAS1 including at least one uneven portion UE1 and UE2 in the concave portion CNC while covering the concave portion CNC.

The uneven portions UE1 and UE2 may be formed in a columnar shape through a dry etching process, but are not limited thereto.

Referring to FIG. 5A, the first uneven portion UE1 may have a structure where an upper end of the protruding portion is recessed inward.

Referring to FIG. 5B, the second uneven portion UE2 may have a shape where an edge portion protrudes and a hollow central portion.

FIG. 5A illustrates an example where only the first uneven portion UE1 is included, and FIG. 5B illustrates an example where only the second uneven portion UE2 is included. However, the first uneven portion UE1 and the second uneven portion UE2 may be randomly distributed or an uneven portion having a shape other than the first uneven portion UE1 or the second uneven portion UE2 may be formed or, as such, various combinations of uneven portions are possible, by adjusting the dry etching process.

Further, the manufacturing method for forming the uneven portions is not limited to the dry etching process, and other various manufacturing methods such as forming an uneven shape by using impurities as a stopper may be used.

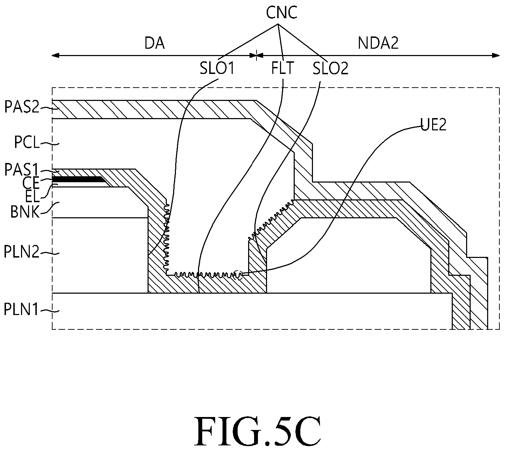

FIGS. 5A and 5B illustrate that the uneven portions UE1 and UE2 are positioned only in the flat portion FLT of the concave portion CNC, but this is exemplary but, without limitations thereto, may also be positioned in the first side portion SLO1 or the second side portion SLO2 as illustrated in FIG. 5C.

FIGS. 5A to 5C illustrate a structure where the organic encapsulation layer PCL covers the uneven portions UE1 and UE2 positioned in the concave portion CNC but, without limitations thereto, there may be uneven portions UE1 and UE2 that do not overlap the organic encapsulation layer PCL.

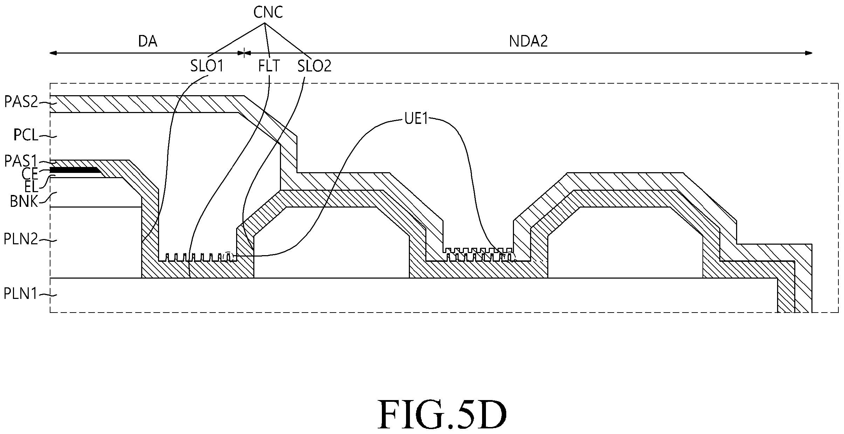

Referring to FIG. 5D, the organic encapsulation layer PCL may cover the concave portion CNC positioned closest to the bank layer BNK among the concave portions, but may not cover the concave portion CNC positioned outside the concave portion CNC positioned closest to the bank layer BNK.

Referring to FIG. 5D, in an area where the organic encapsulation layer PCL does not cover the uneven portion UE1 of the first inorganic encapsulation layer PAS1, the second inorganic encapsulation layer PAS2 may be positioned on the first inorganic encapsulation layer PAS1.

Here, the second inorganic encapsulation layer PAS2 may also be formed in an uneven shape along the uneven shape of the first inorganic encapsulation layer PAS1.

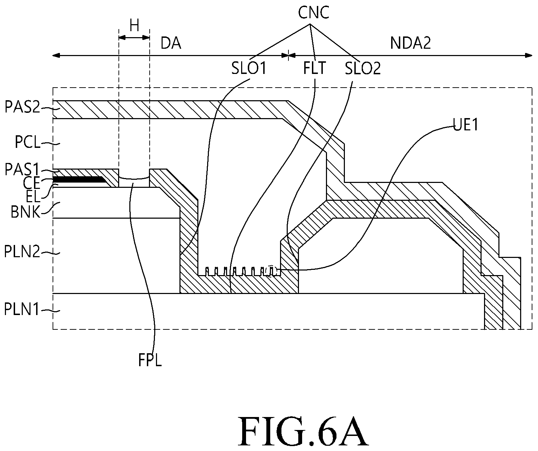

Referring to FIG. 6A, the first inorganic encapsulation layer PAS1 may include at least one hole H positioned on the bank layer BNK. That is, at least one hole H may be formed in the first inorganic encapsulation layer PAS1 and expose the upper surface of the bank layer BNK.

At least one hole H may be positioned in the display area DA.

A pattern layer FPL including fluorine may be included in at least one hole H.

The organic encapsulation layer PCL may cover at least one hole H and the pattern layer FPL in the hole H.

The pattern layer FPL may be positioned on the same layer as the first inorganic encapsulation layer PAS1.

The pattern layer FPL may be a polymer, a single molecule, or a complex including at least one fluorine atom.

For example, the pattern layer FPL may be a polymer including at least one fluorine atom based on a carbon-carbon skeleton.

As another example, the pattern layer FPL may be a single molecule or a complex including at least one fluorine atom based on a carbon-carbon skeleton.

When the pattern layer FPL positioned on the same layer as the first inorganic encapsulation layer PAS1 includes fluorine, moisture penetrating into the interface between the bank layer BNK and the first inorganic encapsulation layer PAS1 may be prevented.

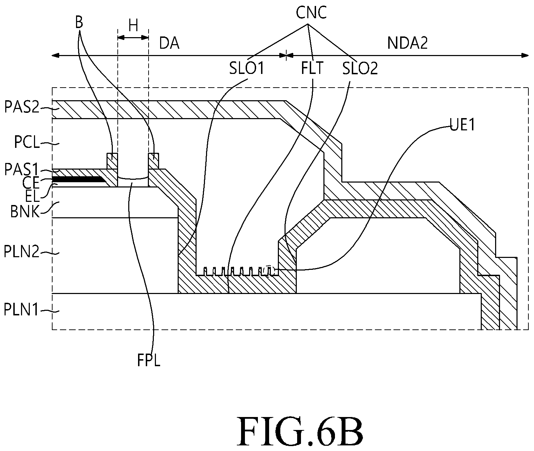

Referring to FIG. 6B, the first inorganic encapsulation layer PAS1 may include a burr B surrounding at least one hole H.

The burr B may be formed of substantially the same material as the first inorganic encapsulation layer PAS1.

The pattern layer FPL may be surrounded by the burr B while being positioned in the hole H.

Here, the organic encapsulation layer PCL may cover the burr B and the pattern layer FPL.

When the burr B is disposed to surround the pattern layer FPL, moisture penetration may be delayed by increasing the movement path of moisture penetrating into the interface between the first inorganic encapsulation layer PAS1 and the organic encapsulation layer PCL by the burr B.

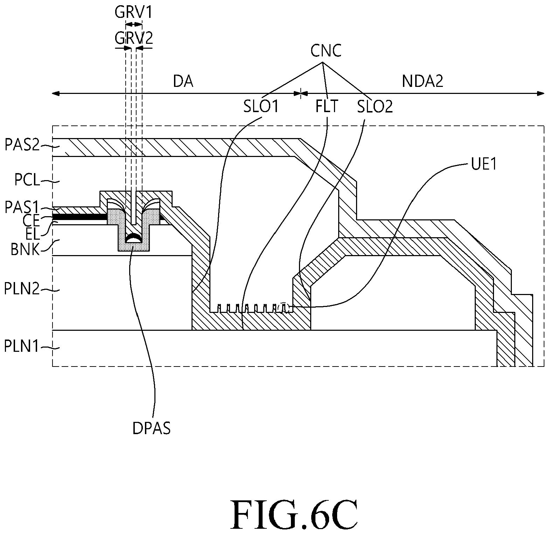

Referring to FIG. 6C, a dummy passivation layer DPAS including a first groove GRV1 may be positioned on the bank layer BNK. The dummy passivation layer DPAS may be disposed in the hole H.

An intermediate layer EL may be positioned on the dummy passivation layer DPAS, and a common electrode CE may be disposed on the intermediate layer EL.

Here, the intermediate layer EL and the common electrode CE positioned in the first groove GRV1 and the intermediate layer EL and the common electrode CE positioned in areas other than the first groove GRV1 may be disconnected from each other.

The first inorganic encapsulation layer PAS1 may cover the intermediate layer EL and the common electrode CE positioned in the first groove GRV1, and the intermediate layer EL and the common electrode CE positioned in the areas other than the first groove GRV1.

When the first inorganic encapsulation layer PAS1 covers the intermediate layer EL and the common electrode CE positioned in the first groove GRV1, and the intermediate layer EL and the common electrode CE positioned in the areas other than the first groove GRV1, the first inorganic encapsulation layer PAS1 may have a second groove GRV2 formed along the shape of the first groove GRV1.

The organic encapsulation layer PCL may cover the second groove GRV2.

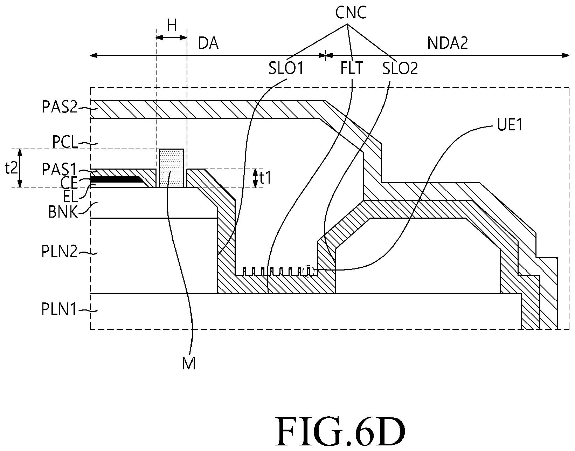

Referring to FIG. 6D, a first inorganic encapsulation layer PAS1 including at least one hole H may be positioned on the bank layer BNK.

Referring to FIG. 6D, a metal protrusion M may be positioned in the hole H.

The metal protrusion M may be positioned on the bank layer BNK.

The metal protrusion M may have a height larger than the depth of the hole H.

In other words, the length t2 of the metal protrusion M may be larger than the depth t1 of the hole H.

The metal protrusion M may be a transition metal or an alloy thereof.

Preferably, the metal protrusion M may include titanium, but is not limited thereto.

FIG. 6D illustrates an example where the metal protrusion M has a vertically tapered shape, but is not limited thereto and may have an inverted tapered shape.

When the metal protrusion M is disposed in the hole H, moisture or hydrogen penetrating into the interface between the first inorganic encapsulation layer PAS1 and the organic encapsulation layer PCL may be prevented or at least reduced.

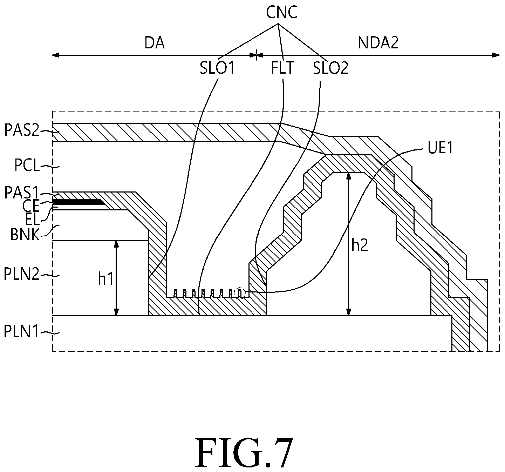

Referring to FIG. 7, the height h2 of the second side portion SLO2 may be larger than the height h1 of the first side portion SLO1 of the concave portion CNC.

When the height h2 of the second side portion SLO2 is larger than the height h1 of the first side portion SLO1 of the concave portion CNC, the planarization layer including the second side portion SLO2 may act as a dam to prevent or at least reduce overflow into the outer area of the non-display area when the organic encapsulation layer PCL is coated, and the moisture penetration may be delayed by increasing the movement path of moisture penetrating into the interface between the organic encapsulation layer PCL and the first inorganic encapsulation layer PAS1.

Embodiments of the disclosure described above are briefly described below.

The present disclosure provides a display device, including: a substrate; a first electrode layer disposed on the substrate; a bank layer disposed on the first electrode layer and configured to define a plurality of subpixels; a light emitting layer disposed on the bank; and an encapsulation layer disposed on the light emitting layer, wherein the encapsulation layer includes a concave portion.

In an embodiment, the display device has a display area and a non-display area around the display area, and wherein at least a part of the concave portion is located in the display area.

In an embodiment, further includes a planarization layer between the substrate and the first electrode layer, wherein the concave portion is located in the planarization layer.

In an embodiment, the encapsulation layer includes: a first encapsulation layer formed of an inorganic material; and a second encapsulation layer formed of an organic material, wherein an uneven pattern is formed at an interface between the first encapsulation layer and the second encapsulation layer.

In an embodiment, the concave portion includes a first side portion, a flat portion, and a second side portion, and wherein the uneven pattern is formed at each of the first side portion, the flat portion and the second side portion.

In an embodiment, further includes a hole formed in the first encapsulation layer, and the hole expose an upper surface of the bank layer.

In an embodiment, a pattern layer is formed in the hole.

In an embodiment, the pattern layer is formed of a polymer, a single molecule, or a complex, and contains fluorine.

In an embodiment, further includes a burr formed on the first encapsulation layer and surrounding the hole.

In an embodiment, further includes a dummy passivation layer disposed on the bank layer and includes a first groove, and wherein the first encapsulation layer forms a second groove along inner surfaces of the first groove.

In an embodiment, further includes a metal protrusion disposed in the hole.

In an embodiment, a height of the metal protrusion is larger than a depth of the hole.

In an embodiment, the first side portion is away from the non-display area than the second side portion, and a height of the first side portion is less than a height of the second side portion.

A display device according to embodiments of the disclosure may comprise a substrate including a display area and a non-display area surrounding the display area, an insulation layer positioned on the substrate and including at least one concave portion in an area adjacent to a boundary between the display area and the non-display area, or the non-display area, a bank layer positioned in the display area, positioned on the insulation layer, and including an opening area, and an inorganic encapsulation layer positioned on the bank layer, covering the concave portion, and including at least one uneven portion in the concave portion.

In the display device according to embodiments of the disclosure, the uneven portion may be positioned lower than the bank layer.

The display device according to embodiments of the disclosure may further comprise an organic encapsulation layer on the inorganic encapsulation layer. The organic encapsulation layer may cover a concave portion positioned closest to the bank layer among the at least one concave portion.

In the display device according to embodiments of the disclosure, the inorganic encapsulation layer may include at least one hole positioned on the bank layer, and may include a pattern layer including fluorine in the hole.

In the display device according to embodiments of the disclosure, the inorganic encapsulation layer may further include a burr surrounding the inorganic encapsulation layer.

The display device according to embodiments of the disclosure may further comprise an organic encapsulation layer on the inorganic encapsulation layer. The organic encapsulation layer may cover the burr and the pattern layer.

In the display device according to embodiments of the disclosure, the pattern layer may be positioned on the same layer as the inorganic encapsulation layer.

In the display device according to embodiments of the disclosure, the bank layer may include at least one first groove positioned between the opening area and the concave portion. The display device may further comprise a passivation layer positioned on the bank layer, covering the at least one first groove, and including at least one second groove positioned on the at least one first groove, and a dummy intermediate layer positioned on an upper surface of the passivation layer.

In the display device according to embodiments of the disclosure, the concave portion may include a first inclined portion adjacent to the opening area and a second inclined portion facing the first inclined portion. A height of the second inclined portion may be larger than a height of the first inclined portion.

In the display device according to embodiments of the disclosure, the inorganic encapsulation layer may include at least one hole positioned on the bank layer, and may include a pattern layer further including a metal protrusion longer than a depth of the hole, in the hole.

In the display device according to embodiments of the disclosure, a dummy intermediate layer positioned in the at least one second groove and a dummy intermediate layer positioned in an area other than the second groove may be disconnected from each other.

A display device according to embodiments of the disclosure may comprise a substrate including a display area and a non-display area surrounding the display area, an insulation layer positioned on the substrate and including at least one concave portion positioned in an area adjacent to a boundary between the display area and the non-display area or in the non-display area, a bank layer positioned in the display area, positioned on the insulation layer, and including an opening area, an inorganic encapsulation layer including at least one hole positioned on the bank layer, and a pattern layer including fluorine in the hole.

In the display device according to embodiments of the disclosure, the inorganic encapsulation layer may further include a burr surrounding the inorganic encapsulation layer.

The display device according to embodiments of the disclosure may further comprise an organic encapsulation layer on the inorganic encapsulation layer. The organic encapsulation layer may cover the burr and the pattern layer.

In the display device according to embodiments of the disclosure, the pattern layer may be positioned on the same layer as the inorganic encapsulation layer.

According to embodiments of the disclosure, a display device may comprise a substrate including a display area and a non-display area surrounding the display area, a bank layer positioned in the display area, positioned on the insulation layer, including an opening area, and including at least one first groove positioned between the opening area and the concave portion, a passivation layer positioned on the bank layer, covering the at least one first groove, and including at least one second groove positioned on the at least one first groove, and a dummy intermediate layer positioned on an upper surface of the passivation layer.

In the display device according to embodiments of the disclosure, the concave portion may include a first inclined portion adjacent to the opening area and a second inclined portion facing the first inclined portion. A height of the second inclined portion may be larger than a height of the first inclined portion.

The display device according to embodiments of the disclosure may further comprise an inorganic encapsulation layer positioned on the dummy intermediate layer and covering the second groove. The inorganic encapsulation layer may include at least one hole positioned on the bank layer, and a pattern layer further including a metal protrusion in the hole.

In the display device according to embodiments of the disclosure, a dummy intermediate layer positioned in the at least one second groove and a dummy intermediate layer positioned in an area other than the second groove may be disconnected from each other.

The above description has been presented to enable any person skilled in the art to make and use the technical idea of the disclosure, and has been provided in the context of a particular application and its requirements. Various modifications, additions and substitutions to the described embodiments will be readily apparent to those skilled in the art, and the general principles defined herein may be applied to other embodiments and applications without departing from the scope of the disclosure. The above description and the accompanying drawings provide an example of the technical idea of the disclosure for illustrative purposes only. That is, the disclosed embodiments are intended to illustrate the scope of the technical idea of the disclosure.

## Claims

1. A display device, comprising:
a substrate;
a first electrode layer on the substrate;
a bank layer on the first electrode layer, the bank layer defining a plurality of subpixels;
a light emitting layer on the bank layer; and
an encapsulation layer on the light emitting layer,
wherein the encapsulation layer includes a concave portion.

2. The display device according to claim 1, wherein the display device has a display area and a non-display area around the display area, and
wherein at least a part of the concave portion is in the display area.

3. The display device according to claim 1 or 2, further comprising a planarization layer between the substrate and the first electrode layer,
wherein the concave portion is in the planarization layer.

4. The display device according to any preceding claim, wherein the encapsulation layer comprises:
a first encapsulation layer including an inorganic material; and
a second encapsulation layer including an organic material, the second encapsulation layer on the first encapsulation layer,
wherein an uneven pattern is at an interface between the first encapsulation layer and the second encapsulation layer.

5. The display device according to claim 4, wherein the concave portion comprises a first side portion, a flat portion, and a second side portion, and
wherein the uneven pattern is at each of the first side portion, the flat portion and the second side portion.

6. The display device according to claim 4 or 5, further comprising a hole in the first encapsulation layer in the display area, the hole exposing an upper surface of the bank layer.

7. The display device according to claim 6, wherein a pattern layer is in the hole.

8. The display device according to claim 7, wherein the pattern layer includes a polymer, a single molecule, or a complex, and contains fluorine.

9. The display device according to any of claims 6 to 8, further comprising a burr protruding from an upper surface of the first encapsulation layer and surrounding the hole.

10. The display device according to any of claims 6 to 9, further comprising a dummy passivation layer on the bank layer, the dummy passivation layer comprising a first groove in the hole,
wherein the first encapsulation layer forms a second groove along inner surfaces of the first groove.

11. The display device according to any of claims 6 to 10, further comprising a metal protrusion in the hole.

12. The display device according to claim 11, wherein a height of the metal protrusion is larger than a depth of the hole.

13. The display device according to any of claims 5 to 12, wherein the first side portion is farther away from a non-display area than the second side portion, and
wherein a height of the first side portion is less than a height of the second side portion.
